# EUROPEAN PATENT APPLICATION

(11) **EP 3 567 128 A1**
(43) Date of publication of application: **13.11.2019**
(21) Application number: 18171343.9
(22) Date of filing: 08.05.2018
(51) Int. Cl.: C23C 14/22, C23C 14/50, C23C 16/458

(54) **DEPOSITION APPARATUS AND METHOD OF COATING SPHERICAL OBJECTS**

(71) Applicant: IHI Hauzer Techno Coating B.V., 5928 LL Venlo (NL)
(72) Inventor: Horstink, Marc Alphonse, 5925 HG Venlo (NL); Dullemeijer, Ernst, 6021 LV Budel (NL)
(74) Representative: Manitz Finsterwald Patent- und Rechtsanwaltspartnerschaft mbB

(57) **Abstract**

The present invention relates to a deposition apparatus for coating spherical objects in a chamber by means of one or more coating sources. The invention further relates to a method of coating spherical objects.

## Description

The present invention relates to a deposition apparatus for coating spherical objects and to a method of coating spherical objects.

It is known to provide various objects with various types of low friction coatings that have an improved resistance to wear, such as, for example, Cr + WC:H or Cr-WC coatings, which are coatings with gradient layers and preferably coatings comprising multi-layers.

Typically the objects are fixed in position in the deposition apparatus and are coated from one side at a time. The fixing of the objects is rather demanding in effort and cost and leads to long cycle and batch times.

In order to reduce the cycle and batch times the use of inline systems is known, however, these do not readily permit the provision of gradient layers or gradient coatings on the objects.

In order to enable the batch processing of articles it is also known to use drum-batch coaters that comprise a horizontally rotating drum and cathodes arranged at their center, however, such systems frequently lead to damaged objects and/or non-uniform and damaged coatings due to the presence of dust that accrues over time in the coating apparatus.

Other batch processing systems use oscillating systems that result in a low production efficiency and increased cost which is generally not desirable.

Moreover, objects that have an at least partially spherical shape are difficult to coat, as part of the shape will have no direct line of sight to the coating cathode and hence will not be coated at all and the remaining surface will also not necessarily be uniformly coated.

For this reason it is an object of the present invention to make available a deposition apparatus and a method by means of which spherical objects can be coated with an as uniform coating as possible with as little damage as possible being introduced into the coating. It is a further object of the invention to provide a coating, e.g. a low friction coating, such as a DLC coating, a Cr + WC:H coating and a Cr-WC coating on ball bearings. It is a further object of the present invention to make available a method of coating spherical objects in a batch process. It is further object of the invention to make available an apparatus or fixture in/at which coatings can be applied on spherical objects using inline systems as well as conventional batch systems.

These objects are satisfied by the subject matter of the respective independent apparatus and method claim. Advantageous embodiments are described in the dependent claims and the following description of preferred embodiments.

Such a deposition apparatus comprises:
a chamber, in particular a vacuum chamber, having a top side and a bottom side and sidewalls connecting the bottom side to the top side, wherein an axis of the chamber extends between the top side and the bottom side,
one or more sources of coating material arranged at one of the top side and the sidewall, with the one or more sources of coating material facing into the chamber, at least one support for the spherical objects disposed in the chamber opposite to the top side and spaced apart from the one or more sources of coating material, at least one device for producing rotational movement of the objects around first and second axes relative to the at least one support, with the second axis being arranged oblique to the first axis, i.e. a device causing the spherical objects to rotate relative to the deposition apparatus.

By making available a deposition apparatus that imparts a rotational movement to the spherical objects to be coated ensures that every part area of the outer surface of the spherical objects can be uniformly coated, as every part surface of the spherical objects can be exposed to the source of coating for the same period of time ensuring the formation of a uniform coating.

Moreover, by causing the spherical objects to rotate about two axes about themselves within the chamber, each part surface of the object is subjected several times to the one or more sources of coating material during one coating cycle making available the possibility to form gradient layers and/or multiple layers on the spherical object. Such gradient layers for example comprise Cr-WC, with a WC layer having an increasing Carbon content. Coatings comprising gradient layers and/or multiple layer structures can have a particularly good adhesion on the object to be coated in comparison to single layer structures.

Forming a uniform coating, e.g. a low friction coating having a good resistance to wear, on ball bearings is particularly desirable, as any non-uniform coating on a ball bearing will lead to increased friction the ball bearing experiences e.g. when running relative to a bearing race.

By use of such a system the coating of ball bearings with a friction reduced coating having an improved resistance to wear is made possible at an industrially acceptable level, which opens the possibilities to apply PVD coatings on large scale and such contribute to the reduction of energy in the production of coatings. Such coatings can be applied in all sorts of fields of industry, for example in the automotive field, the aerospace field, with regard to bicycles and in the production of wind energy.

The spherical objects are caused to rotate about a second axis, the second rotational motion of the objects is brought about by an additional mechanism or device that causes the spherical objects to spin, i.e. rotate about their own axis or axes relative to the support.

By mounting the cathodes of the sources of coating material at the top of the system they are simple to access for servicing etc. Moreover, they are arranged in a fixed position relative to the moveable objects which simplifies the coating process.

By rotating the spherical objects about the axis of the chamber and relative to the cathodes of the sources of coating material each spherical object sees each cathode a plurality of times enabling the formation of multiple layers and/or gradient layers on the spherical objects if different types of cathodes are used and/or if the ratios of a gas introduced at the cathode is varied in time.

Spherical objects of various diameters can be inserted into one and the same deposition apparatus and can be uniformly coated. In this connection it should be noted that in some instances the deposition apparatus does not require adaptation for spherical objects of various diameters, in other apparatus, at least one of the support, the device and the fixture require adapting.

Preferably the at least one support is one of a fixed table and a table rotatable about the axis. In this way the spherical objects can either be rotated by the table or relative to the table about the axis of the chamber and can be caused to rotate about themselves.

According to an embodiment the deposition apparatus further comprises one or more fixtures, wherein the one or more fixtures are arranged on the support and comprise one or more tables rotatable about the axis of the chamber. The use of fixtures for coating spherical objects means that these can be coated in existing deposition apparatus.

Advantageously the deposition apparatus further comprises one or more tracks configured to constrain the movement of the objects around the axis. The use of tracks, on the one hand, ensures a more controlled guidance of the spherical objects within the chamber. On the other hand, the spherical objects can be lifted from the support or table on which they can rotate by means of the tracks ensuring that dust accruing in the chamber can fall away from the spherical objects. The removal of dust is very beneficial, as dust can cause damage to coatings if the dust adheres to the spherical objects.

It is preferred if the track is selected as one of a circular track, a spiral track, a circular track with deflectors, and a non-circular closed loop track. Such tracks can be selected to aid the introduction of rotational components at the spherical objects.

Preferably each track is formed by first and second rails, with the first rail being configured to be moved around the axis, optionally while the second rail is fixed in position relative to the axis. By moving one of the rails relative to the other rail around the axis of the chamber further rotational components can be imparted onto the spherical object further enhancing the fact that each part surface of each spherical object can be provided with the same thickness of coating, i.e. a moveable ensures the formation of a uniform coating on the spherical objects.

Advantageously each track is formed by first and second rails, with deflection elements being arranged between the first and second rails. The use of deflection elements enhances the introduction of rotational components into the rotational motion of each spherical object.

It is preferred if each track is formed by first and second rails, with each of the first and second rails comprising a longitudinal axis and with at least the first rail being configured to be rotated about its longitudinal axis. The use of rotating rails enhances the introduction of rotational components into the rotational motion of each spherical object.

Preferably each track is formed by first and second rails, wherein each of the first and second rails comprises a longitudinal axis and at least some of the first and second rails each comprising at least one rotatable segment arranged along the longitudinal axis of the rail, with the at least one rotatable segment being configured to be rotated about the longitudinal axis, optionally while the remainder of each rail is fixed in position. The use of rails comprising rotatable segments enhances the introduction of rotational components into the rotational motion of each spherical object.

Advantageously each track is formed by first and second rails, wherein the first and second rails comprise a curved surface, with the curved surface being arranged at least in a region in which the track is configured to constrain the movement of the spherical objects. By forming the surface of the first and second rails curved these avoid scratches from being introduced into a surface of the spherical objects and enable dust to fall off the rails, thereby the coating results achieved therewith can be improved. It should be noted in this connection that a rectangular rail would not necessarily lead to scratched surfaces, but would not enable the dust to fall off.

It is preferred if the at least one device comprises one or more wiper arms extending outwardly relative to the axis, the arms extending either radially or in an axial plane inclined with respect to a radial direction. The wiper arms entrain the spherical objects about the axis of the chamber and cause the inherent rotational motion of the spherical objects.

Preferably the device comprises one of a disc shaped basket having a base for carrying the spherical objects and a plurality of segment shaped baskets each having a base for carrying the spherical objects, and the support optionally comprises a table supporting the basket(s). Providing one or more baskets that can be introduced into the chamber facilitates the introduction and removal of the spherical objects in the chamber.

Advantageously the base of the or each basket is inclined with respect to the axis of the chamber, for example, in the manner of a swash plate. By arranging the baskets inclined with respect to the axis ensures an introduction of two or more rotational components into the rotational motion of the spherical objects.

It is preferred if the basket(s) either rotate(s) with the table or relative to the table, optionally about an axis eccentric to an axis of the table. By rotating the baskets relative to the table two components of rotational motion can be imparted to the spherical objects, this can be particularly enhanced by an eccentric motion of the two parts.

Preferably the or each base is formed as a grid having apertures for the spherical objects and the or each basket rotates relative to the table. Such apertures or grids enable dust to fall away from the spherical objects improving the quality of coating through the lack of dust. Moreover, such grids aid the introduction of rotational motion that is required to create a more uniform coating at the spherical objects.

Advantageously the apertures comprise segments of a rail of a track. In this way a direction of motion of the spherical objects can be controlled.

In this connection it should be noted that it is preferred if the apertures are configured to engage the spherical objects at an equator, in a plane above the equator or in a plane below the equator. Depending on the arrangement of the apertures the amount of dust removed can be better controlled.

Preferably the deposition apparatus further comprises at least one motor for driving the support and/or the device around the axis. The motor can e.g. be an electric motor that brings about the rotation of the support, such as a table, the device, such as a wiper arm or the basket.

Advantageously the device comprises at least one deflection member that is configured to be moved in at least one of a radial direction with respect to the axis and in parallel with the axis. The use of such a deflection member can introduce a further rotational component into the rotational motion of the spherical object.

It is preferred if the deposition apparatus further comprises a spiral track that extends between the axis and an outer side of the support having an introduction end and an extraction end, with the spiral track comprising at least one rail for constraining the movement of the spherical object between the introduction end and the extraction end, wherein each of the at least one rails comprises a curved surface, with the curved surface being arranged at least in a region in which the rail is configured to constrain the movement of the spherical objects.

Through the use of a spiral type of grid the spherical objects roll by gravity from a introduction end to an extraction end and can easily be introduced into the chamber and subsequently removed, i.e. the advantage of this type of track design is that it facilitates the loading and unloading of the spherical objects. It is also possible to return the spherical objects to the start by means of a returning mechanism such as a screw like conveyor that enables thicker layers of coating to be applied at the spherical objects, since the spherical objects pass by the sources a multiple of times.

It is preferred if a plurality of coating sources are provided, with two, three or more different kinds of coating sources being provided and optionally with several of each kind of coating source being provided

Advantageously the coating sources are selected from the group of members consisting of: a PVD coating source, a PaPVD coating source, a CVD coating source, a PeCVD coating source, a HIPIMS source, a dual magnetron sputtering source, a microwave source, a glow discharge source, a plasmasource, a rotatable magnetron, an arc source, a pulsed arc source, a sputtering source, a filtered arc source and combinations of the foregoing.

Preferably each of the one or more coating sources comprises a cathode that faces into the chamber, wherein the cathode is optionally a circular shaped cathode, a rectangular shaped cathode, a pie shaped cathode or a square shaped cathode.

Advantageously the one or more coating sources are provided to form single layers, gradient layers and/or multiple layers of different materials on the spherical objects. It is also possible to bias the spherical objects in the chamber. It is further possible to etch the spherical objects through the use of e.g. microwaves, a plasma source or glowdischarge.

It is particularly preferably to form non-conductive coatings at the spherical objects by means of a combination of dual Magnetron technology and microwave technology.

According to a further aspect the present invention relates to a fixture for a deposition apparatus, preferably in accordance with the teaching presented herein, wherein the fixture comprises a plurality of tables rotatable about an axis of rotation, with the plurality of tables being arranged one after another along said axis of rotation, wherein each table of the fixture comprises at least one of:
one or more tracks arranged on said table and said tracks being configured to constrain the movement of the spherical objects around the axis of rotation;
at least one device for producing rotational movement of the spherical objects around first and second axes relative to the table, with the second axis being arranged oblique to the first axis; and
one of a disc shaped basket having a base for carrying the spherical objects and a plurality of segment shaped baskets each having a base for carrying the spherical objects.

By means of such a fixture spherical objects can be coated in inline systems and in batch coating systems. Such fixtures can thus be retrofitted at existing deposition apparatus.

According to a further aspect the present invention relates to a method of coating spherical objects, the method comprising the steps of:
- introducing the spherical objects into a deposition apparatus;
- producing a rotational movement of the objects around first and second axes relative to at least one support for the spherical apparatus, with the at least one support being arranged within the deposition apparatus,
- optionally etching surfaces of the spherical objects prior to coating the spherical objects; and
- depositing a coating on the spherical objects by means of one or more sources of coating material arranged at the deposition apparatus and facing into a chamber of the deposition apparatus.

By way of this method spherical objects can be coated with a more uniform coating in comparison to prior art coatings with the number of failed coatings being reduced in comparison to the prior art. In this way the advantages discussed in the foregoing can likewise be achieved by the method in accordance with the invention.

In accordance with a further aspect the above object is satisfied by a method of coating spherical objects arranged at a fixture, the method comprising the steps of:
- introducing the spherical objects into said fixture, in particular in accordance with the teaching presented herein;
- producing a rotational movement of the spherical objects around first and second axes relative to an axis of rotation of a table supporting the spherical objects, with the table being arranged at the fixture,
- optionally etching the spherical objects at the fixture prior to coating the spherical objects; and
- depositing a coating on the spherical objects by rotating these relative to at least one source of coating material.

Further embodiments of the invention are described in the following description of the Figures. The invention will be explained in the following in detail by means of embodiments and with reference to the drawing in which is shown:
- Fig. 1a & 1b: a top view and a side view of a deposition apparatus;
- Fig. 2a & 2b: top views of further deposition apparatus;
- Fig. 3a to 3f: various views of parts of various deposition apparatus;
- Fig. 4a & 4b: various views of a further type of deposition apparatus;
- Fig. 5a & 5b: various views of a further type of deposition apparatus;
- Fig. 6a to 6d: further views of parts of a further type of deposition apparatus;
- Fig. 7a to 7c: further views of parts of a further type of deposition apparatus;
- Fig. 8a to 8c: further views of parts of a further type of deposition apparatus illustrating a rotational movement of spherical objects around first and second axes;
- Fig. 9a to 9c: further views of parts of a further type of deposition apparatus;
- Fig. 10a & 10b: further views of the deposition apparatus of Fig. 9a to 9c;
- Fig. 11: shows a view of parts of a further deposition apparatus comprising a spiral track formed on its table;
- Fig. 12a to 12f: various views of batch processing systems comprising one or more fixtures; and
- Fig. 13a & 13b: a schematic top view of parts of an inline coating system comprising a plurality of fixtures and a schematic side view of the fixtures arranged in the inline coating system.

In the following the same reference numerals will be used for parts having the same or equivalent function. Any statements made having regard to the direction of a component are made relative to the position shown in the drawing and can naturally vary in the actual position of application.

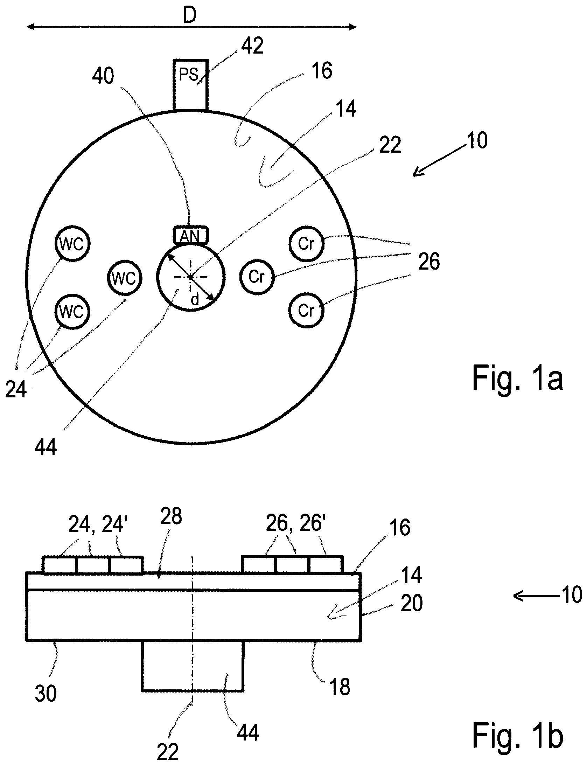

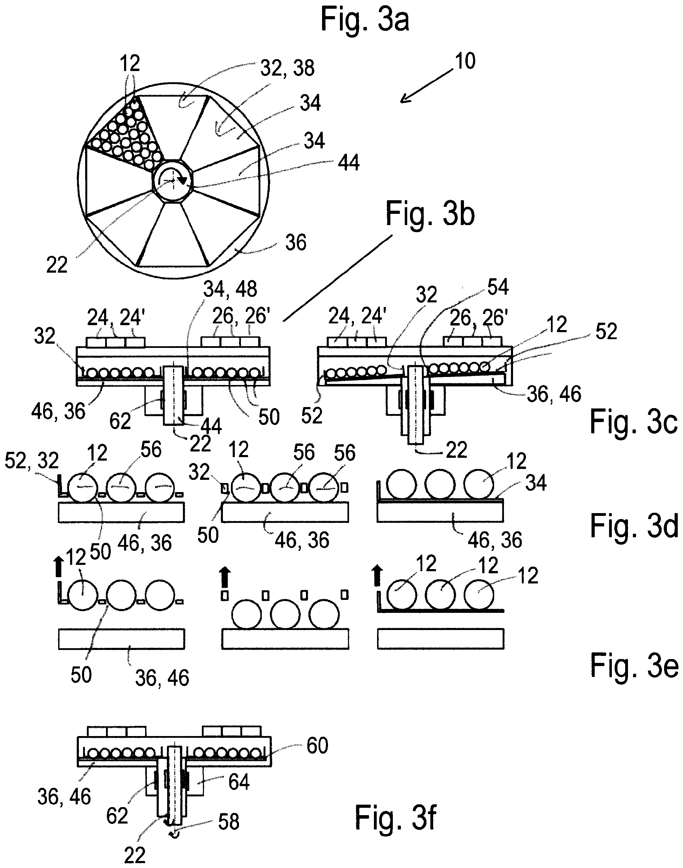

Fig. 1a shows a top view onto a deposition apparatus 10 for coating spherical objects 12 (see Fig. 3a). The deposition apparatus 10 comprises a chamber 14 having a top side 16, a bottom side 18 (see Fig. 1b) and sidewalls 20 (see Fig. 1b) connecting the bottom side 18 to the top side 16. An axis 22 of the chamber extends between the top side 16 and the bottom side 18.

In the example of Fig. 1a and 1b two different kinds of sources 24, 26 of coating material are provided. The first kind of source 24 of coating material 24 is a source of WC. In the present example three such first sources 24 of coating material are provided.

The second kind of source 26 of coating material provided is a Cr source 26 of coating material. In the present example three such second sources 26 of coating material are provided.

In this connection it should be noted that one two, three or more different kinds of sources 24, 26 of coating material can be provided. Likewise one, two or three of each kind of source 24, 26 of coating material can be provided.

As indicated in Fig. 1b the first and second kinds of sources 24, 26 of coating material are arranged at the top side 16 of the chamber 14 and face into the chamber 14.

In this connection it should be noted that the sources 24, 26 of coating material are selected from the group of members consisting of: a PVD coating source, a PaPVD coating source, a CVD coating source, a PeCVD coating source, a HIPIMS source, a dual magnetron sputtering source, a microwave source, a glow discharge source, a plasmasource, a rotatable magnetron, an arc source, a pulsed arc source, a sputtering source, a filtered arc source and combinations of the foregoing.

In the present example the coating sources are PACVD coating sources that work in cooperation with a microwave source. The products can be etched by a plasma source 42 or a glowdischarge source or a microwave source additionally an adhesion layer can be deposited by a sputter source. The top coating is deposited by microwave, using precursor or hydrocarbon gasses. The microwave source enables deposition of non-conductive coatings and diamond like carbon coatings.

Naturally speaking any of the aforementioned coating sources can be used to form single layers, gradient layers and/or multiple layers on the spherical objects 12 in a manner known per so the person skilled in the art.

Such coating sources comprise a cathode 24', 26'. In the example of Fig. 1a and 1b the respective cathode is a circular shaped cathode. The cathodes 24', 26' are arranged at a lid 28 of the chamber 14 that interacts with a base 30 of the chamber 14.

The spherical objects 12 can be inserted and removed via the lid 28.

Rather than having a lid 28 forming the top side 16 that is removable from the base 30, it is also possible to form part of the sidewall 20 as part of a lock system via which the spherical objects 12 can be introduced and/or removed from the chamber 14.

The chamber 14 is typically a vacuum chamber and can be evacuated to the such pressures that are required to carry out the coating and/or etching processes desired to coat the spherical objects 12.

By way of example, the chamber 14 can be evacuated to pressures of between atmospheric pressures and up to 10⁻⁷ mbar. Particularly good coating results are achieved if the vacuum chamber is evacuated to pressures in the range of 10⁻⁴ mbar, preferably in the range of 10⁻⁵ mbar before the coating and/or etching process takes place.

The chamber 14 has an outer diameter D that can be selected in the range of 0.2 to 3m, in particular 0.2 to 1.5 m, depending on the desired application.

The deposition apparatus 10 comprises the plasma source 42 for etching the spherical objects 12. The plasma source 42 is connected to an anode 40 that is arranged within the chamber 14 and that is arranged at an internal member 44. In use of the deposition apparatus 10, the spherical objects 12 are moved about the internal member 44. The spherical objects 12 are biased via a separate power supply (not shown) and during the coating process the chamber 14 is the anode for the biased spherical objects 12.

The anode 40 is connected to the plasma source 42 arranged outside of the chamber 14. The internal member 44 has a diameter d that can be selected in the range of 0.5 to 0.2 m.

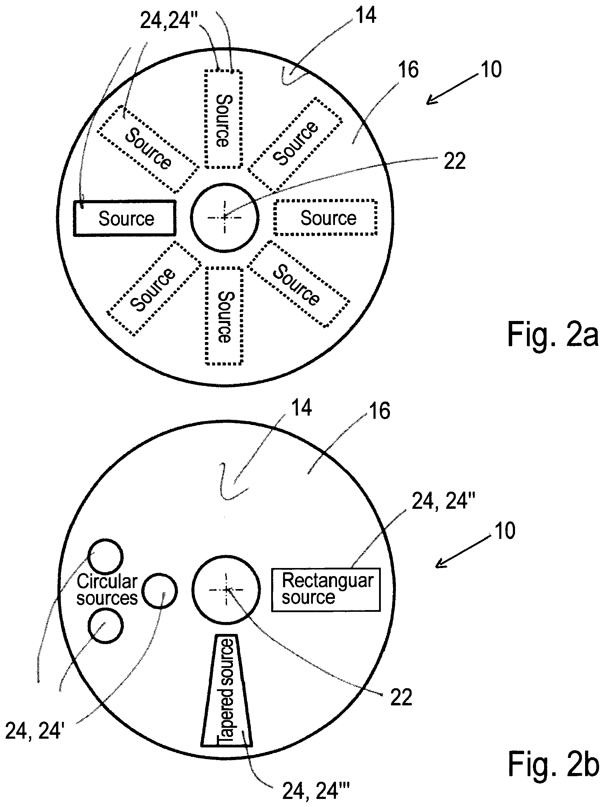

Figs. 2a and 2b show that the sources 24, 26 of coating material can be provided with other shapes of cathodes 24', 24", 24"'. For example, rectangular shaped cathodes 24" (see Figs. 2a and 2b), pie shaped cathodes 24"'(see Fig. 2b) or square shaped cathodes (not shown) could be used.

The specific shape to be used depends on the number of each kind of source of material that is desired to be arranged within the chamber 14. Moreover, as indicated in Fig. 2b various shapes of cathodes 24', 24", 24'" can be arranged at one deposition apparatus 10. In this case different kinds of sources 24, 26 of coating material have cathodes of different shape.

Fig. 3a shows a top view onto the deposition apparatus 10 with the lid 28 removed. Eight segment shaped baskets 32 are arranged within the chamber 14. Each of the segment shaped baskets 32 has a base 34 that is configured to carry the spherical objects 12. Each base 34 of the basket is arranged on a support 36 that is disposed in the chamber 14 opposite to the top side 16 and spaced apart from the one or more sources 24, 26 of coating material.

Each basket 32 is a part of a device 38 that is used to produce a rotational movement of the spherical objects 12 around the internal member 44. In order to carry the baskets the support 36 comprises a table 40 supporting the baskets 32.

Fig. 3b shows a schematic sectional view of the chamber 14. In use of the deposition apparatus 10, at least one of the baskets 32 and the support 36 can be rotated about the axis 22 in order to effect the movement of the spherical objects 12. In the example of Fig. 3b each base 34 is formed as a grid 48 having apertures 50 for the spherical objects 12. Each basket 32 rotates relative to the table 46 to bring about the movement of the spherical objects 12 that are caused to roll on the table 46 by the relative rotational movement between the table 46 and the baskets 32.

Fig. 3c shows a schematic sectional view of another chamber 14. In this example the base 34 of each basket 32 is inclined with respect to the axis 22 of the chamber, for example, in the manner of a swash plate.

The base 32 of each basket 32 does not comprise a grid or apertures, but is rather present in the form of a continuous plate. The baskets 32 are caused to rotate and the spherical objects 12 rotate around the axis 22. The spherical baskets 32 each have outer sidewalls 52 as well as inner sidewalls 54. These prevent the spherical objects 12 from falling out of the baskets 32 as this rotates about the axis 22.

As indicated in Fig. 3d the apertures 50 are configured to engage the spherical objects 12 at an equator 56 (middle drawing) in a plane below the equator 56 (left hand drawing) or in a plane above the equator 56 (not shown). The right hand drawing of Fig. 3d shows a more detailed view of the baskets of Fig. 3c.

Fig. 3e shows the effect the lifting of each basket 32 of Fig. 3d. In the left and right hand examples the baskets 32 are lifted and thereby lift away the spherical objects so that these can be removed from the chamber 14 via the baskets 32.

In the middle drawing of Fig. 3e the spherical objects 12 remain on the table 46. They can be removed from the table 46 e.g. through use of a magnet (not shown) that applies a magnetic force on the spherical objects 12 so that these can be removed, e.g. to the right of the drawing, in a plane perpendicular to a top surface 60 of the table 46.

Depending on the precise design of the deposition apparatus 10, the baskets 32 can either rotate with the table 46 or relative to the table 46.

This means that the table 46 can be actively driven by means of a motor 62 (see Fig. 3f) arranged within the internal member 44 and the spherical objects 12 then roll on the top surface 60 of the table 46 relative to the baskets 32.

Alternatively or additionally, the baskets 32 are also actively driven relative to the table 46. For this purpose the table 46 can be a fixed table 46. If both the table 46 and the baskets 32 are actively driven, i.e. are rotatable, then these can be driven at different rotary speeds to ensure that the spherical objects 12 are caused to rotate within the chamber 14.

As indicated in Fig. 3f the baskets 32 are driven relative to the table 46. The axis 22 of the table 46 is eccentric to an axis 58 of rotation of the baskets 32. By driving the table 46 eccentrically with respect to the baskets 32 the spherical objects 12 can be rotated about several axes relative to the top surface 60 of the table 46.

It is possible that the grid 48 of each basket 32 comprises segments of a track (not shown) that are configured to constrain the movement of the spherical objects 12 around the axis 22.

In order to drive the table 46 respectively the support 36 and/or the device 38 respectively the baskets 32, the deposition apparatus 10 further comprises the motor 62. It is possible that each of the components is driven via a separate motor (not shown). The motor 62 is arranged within a base part 64 of the chamber 14 that houses the internal member 44.

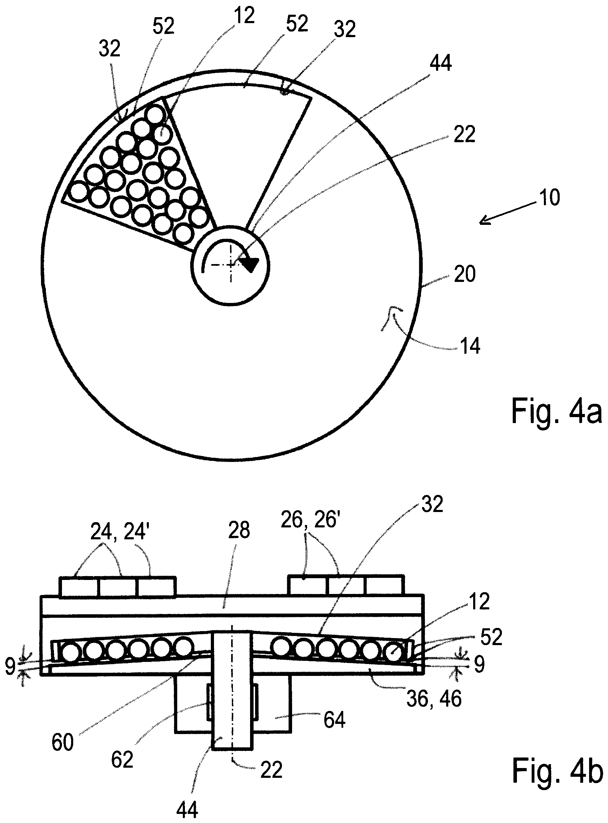

Fig. 4a shows a further design of the deposition apparatus 10. In the present instance the support 36 has the shape of a truncated cone in the sideview as shown in Fig. 4b. As the baskets 32 rotate about the axis 22, the inclined top surface 60 in connection with the rotation of the baskets 32 about the axis 22 causes the spherical objects 12 to rotate about two axes relative to the top surface 60 of the table 46.

As further indicated in Fig. 4b, the baskets 32 do not comprise a base 34 the spherical objects 12 are held within the baskets due to sidewalls 52, 54, 68.between the baskets 32 and the table 46. The sidewall 52 of each basket is spaced apart from the table 46 by a gap g. The gap g can be selected to have a size in the range of 0.1 mm to 4 mm. The gap g is provided so that any dust that may accrue in the chamber 14 during a coating process is able to be removed via the gap g, either by gravity or by arranging a further vacuum pump (not shown) in the region of the gap g for the removal of dust.

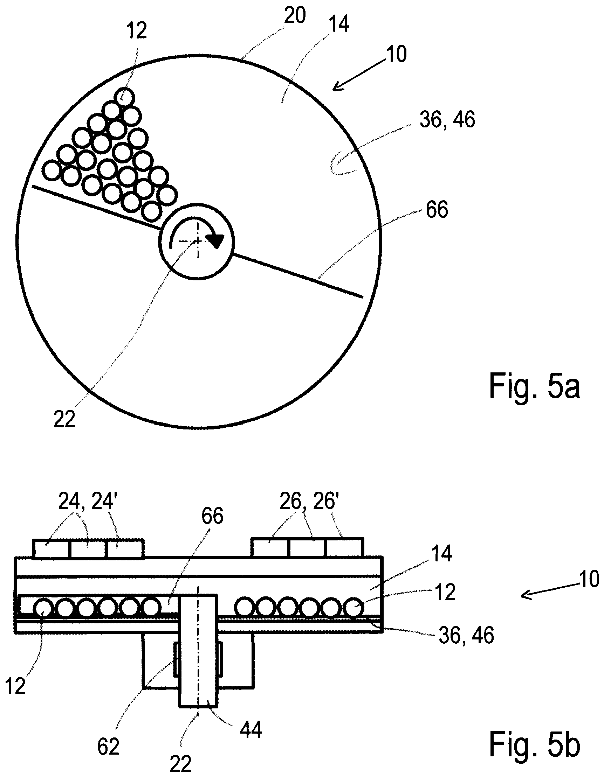

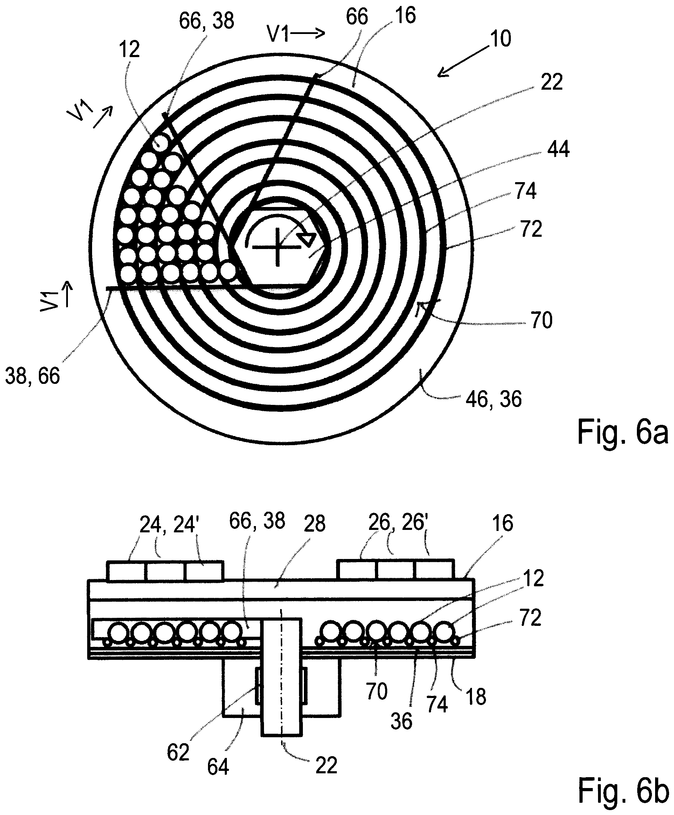

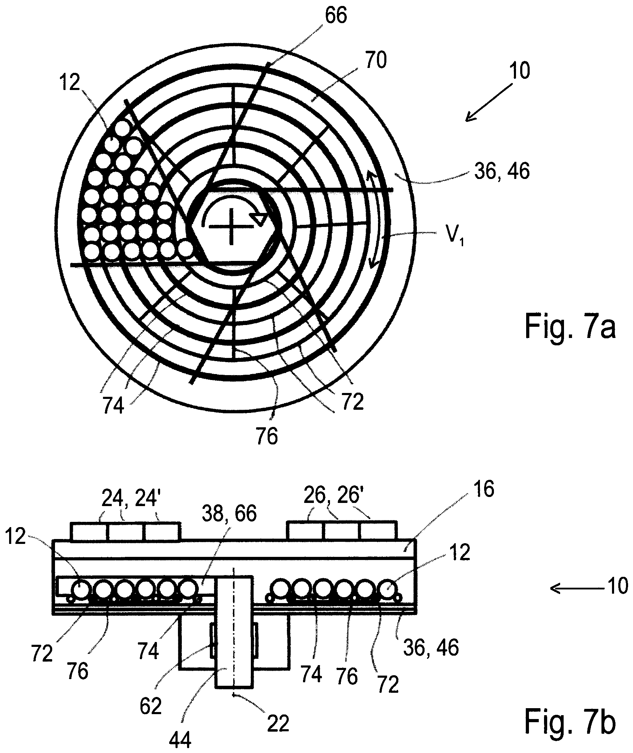

Fig. 5a shows a further design of the deposition apparatus 10. In the present instance the support 36 is formed by a fixed table 46 and the device 38 is formed by a wiper arm 66. The wiper arm 66 extends outwardly relative to the axis 22 and is also driven by the motor 62. By rotating the wiper arm 66 about the axis 22 the spherical objects 12 are caused to rotate about the axis 22. The wiper arm 66 extends radially with respect to the axis 22. As indicated in e.g. Fig. 6a and 7a, a plurality of wiper arms 66 are possible.

Fig. 6a shows a further example of the deposition apparatus 10. This comprises several tracks 70 configured to constrain the movement of the spherical objects 12 around the axis 22. The table 46 is fixed and the device 38 comprises several wiper arms 66 that each extend in an axial plane inclined with respect to a radial direction.

Each track 70 is formed by first and second rails 72, 24. The wiper arms 66 entrain the spherical objects 12 between the rails 72, 74 thereby rotating the spherical objects 12 about the axis 22. The wiper arms 66 also cause the spherical objects 12 to rotate about themselves about an axis that extends in parallel to a radial direction rather like a top spin on a golf ball.

Moreover, due to the difference in radius of the first and second tracks 72, 74 the spherical objects 12 also rotate about a second axis that is inclined with respect to the axis of the spherical object 12 that extends in parallel to the radial direction, i.e. generally in parallel to the top surface 60 of the table 46.

The component of rotation introduced due to the difference in radii between the first and second rails 72, 74 is rather like a hook or a slice spin introduced into a golf ball if this is not accurately hit. In this way the spherical objects 12 are caused to rotate about two axes about themselves on being moved on the tracks 70 by means of the wiper arms 66.

The wiper arms are moved in the direction of the arrow v₁ about the axis 22 and thereby cause the spherical objects 12 to move about the axis 22 of the chamber 14.

As indicated in Fig. 6b, the first and second rails 72, 74 can be circular in a cross-section perpendicular to their longitudinal extent. In this way the first and second rails 72, 74 comprise a curved surface, with the curved surface being arranged at least in a region in which the track is configured to constrain the movement of the spherical objects 12. By forming the surface of the first and second rails 72, 74 curved these avoid scratches from being introduced into a surface of the spherical objects 12 and can thereby improve the coating results achieved thereby.

Rather than using first and second rails having a circular cross-section perpendicular to their longitudinal extent other shapes of rails are possible. For example rails having a V-shaped groove in a cross-section perpendicular to the longitudinal extent are possible.

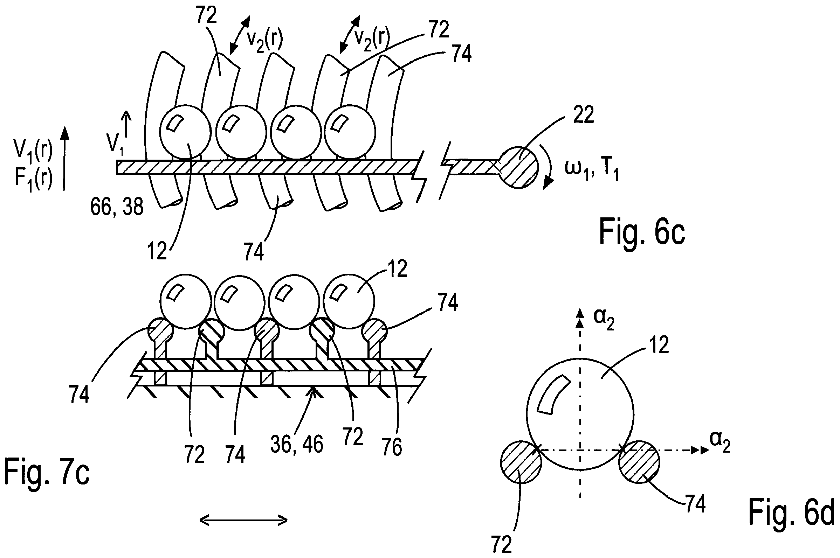

In order to enhance the rotation about the two axes of the spherical object 12, the respective first rail 72 can be configured to be rotated about the axis 22 in the direction of its longitudinal axis, i.e. the axis that extends in parallel to the translationary direction of movement of the spherical object 12, i.e. in the direction of the arrow v₁. Fig. 6c shows such an arrangement where two first rails 72 in the part schematic view are configured to rotate about their longitudinal axis as indicated by the arrows v₂, whereas the second rails 74 are fixed in position and do not rotate.

In this connection it should be noted that the speed of rotation of the respective rail 72, 74 can be varied. It can changed from fast to slow in one direction or even in two directions, The speed of rotation can also be caused to oscillate.

Fig. 6d shows a further schematic sectional view of the deposition apparatus of Fig. 6a. Two arrows α₁ and α₂ are indicated on the spherical object 12 that indicate the two directions of rotational motion the spherical objects 12 adopt when in the deposition apparatus 10.

The first arrow α₁ is directed at least substantially in the direction of translationary motion the spherical object 12 adopts due to the wiper arm 66 entraining the spherical object 12, i.e. in the direction of the longitudinal axis. The second arrow α₂ indicates a rotational component introduced due to the rotation of the first rail 72 that is configured to rotate about itself.

In the example of Fig. 6a the track 70 is a circular track. Different designs of track 70 are possible. By way of example the track 70 could be designed as a spiral track, a circular track with deflectors, and a non-circular closed loop track.

In this connection it should be noted that the at least two directions of rotational motion the spherical objects 12 adopt due to the movement of the wiper arm 66 and the rotating rail 72 are also brought about at the spherical objects 12 by different means in the various deposition apparatus 10 discussed herein.

Fig. 7a to 7c show a further example of a deposition apparatus 10 comprising tracks 70. As indicated in Fig. 7b the first rail 72 is configured to be moved around the axis 22 in the direction of the arrow v₁, while the second rail 74 is fixed in position relative to the axis 22. For this purpose the first rails 72 are connected to one another with a connecting member 76 that can be moved to the left and the right in the plane of the drawing of Fig. 7b and as shown in Fig. 7c by the double headed arrow. The movement to the left and the right of the first rail 72 also causes the spherical objects 12 to be deflected so that these comprises two rotational components about at least two axes.

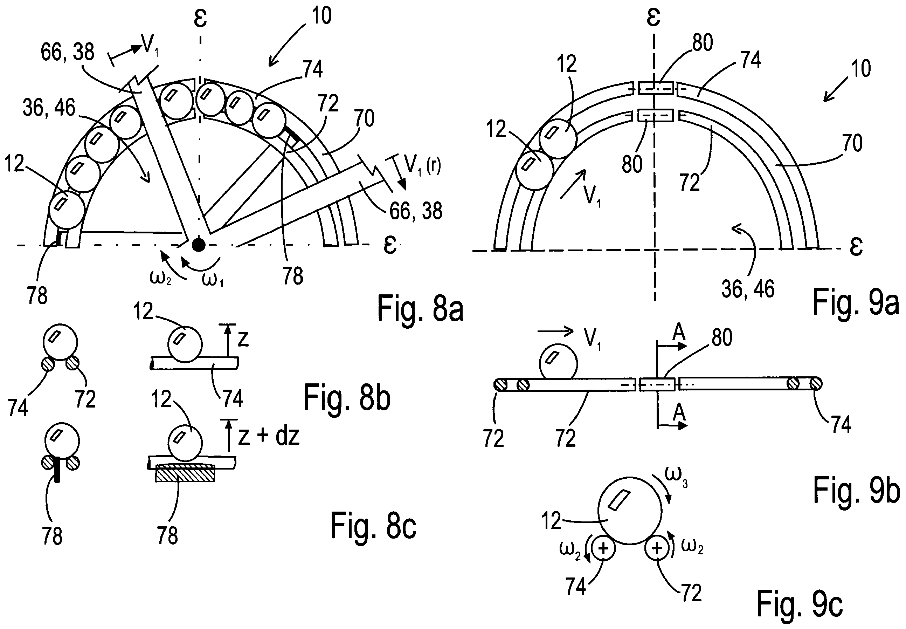

Fig. 8a to 8c shows an arrangement of part of a further type of deposition apparatus 10. In the present example, deflection members 78 are arranged within the track 70 between the first and second rails 72, 74. The deflection members 78 are arranged such that they move a part of the spherical objects 12 up and down in the z-direction (see Fig. 8b) which is arranged at least substantially in parallel to the axis 22 of the chamber 14.

In essence the deflection member 78 is provided to lift the spherical object 12 from one of the rails 72, 74 and thereby produces different contact points for the spherical objects 12. This produces a different angle of rotation of the spherical objects 12. Thus, each time a spherical object 12 comes into contact with a deflection member 78, the axis of rotation of the spherical object 12 will be re-orientated, i.e. it will be altered.

Additionally or alternatively (not shown) the deflection member 78 could also be arranged to move the spherical objects 12 also in the radial direction, i.e. the direction extending perpendicular to the axis 22. Alternatively the deflection members 78 could also rotate around the axis 22 with a different rotational speed in order to alter the point about which the spherical object 12 is rotated.

By introducing the deflection member 78 into the track the movement of the spherical objects 12 is changed thereby introducing another rotational component about which the spherical object 12 rotates while it is moved around the axis 22 of the chamber 14.

Fig. 9a shows parts of a further type of deposition apparatus 10 from above. In this example rotatable segments 80 are introduced into the first and second rails 72, 74 along the longitudinal axis of the respective rail 72, 74. In this example the rotatable segments 80 are inserted into the track 70, rather than forming the complete first or second rail 72, 74 such that they can be rotated about their longitudinal axis.

Fig. 9b shows a side view of the parts of Fig. 9a, as the spherical objects 12 are entrained in the direction v₁, the rotatable segments 80 are rotated relative to the spherical object 12 in order to introduce a second axis of rotation into the rotational movement of the spherical object 12 when the spherical objects 12 pass the rotatable segment 80. If one or more rotatable segments 80 are provided at the first and second rails 72, 74, the remainder of each rail 72, 74 is typically fixed in position.

Fig. 9c shows a section of the parts of Fig. 9b at the sectional line A:A, as indicated the rotatable segments rotate with angular components ω₂ and the spherical object 12 is rotated with an angular component ω₃ introduced by the rotatable segments 80 rotating at a speed proportional to ω₂.

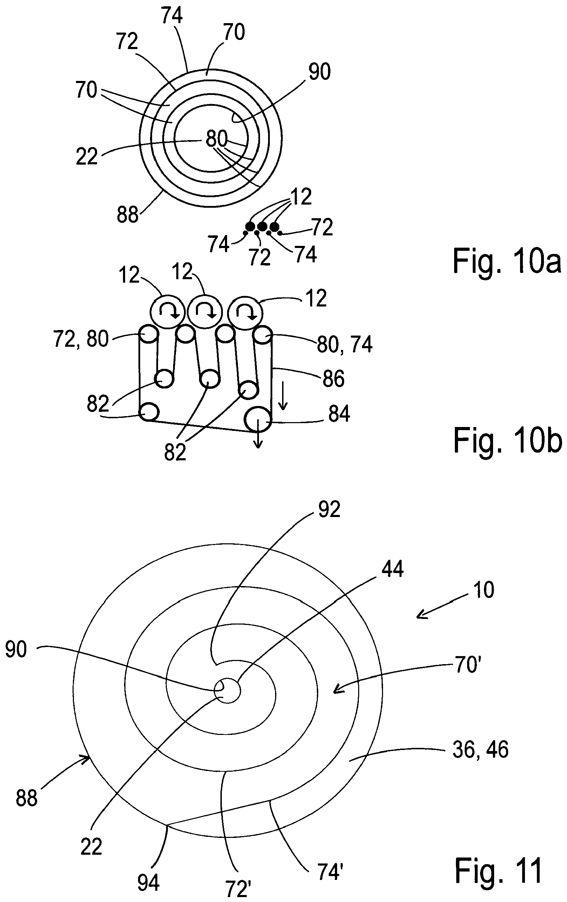

Fig. 10a like Fig. 9 shows a deposition apparatus 10 comprising rotatable segments 80 that are arranged within the first and second rails 72, 74. The rotatable segments 80 are arranged in a zone with activated rotation.

Fig. 10b shows an exemplary drive used to bring about the rotation of the rotatable segments 80. A belt 86 is arranged such that it runs over the rotatable segments 80 of the track 70. The belt is actively driven and when the spherical objects 12 pass the rotatable segments 80 they are forced to rotate about an axis perpendicular to the axis of their translationary movement.

The belt 86 preferably has a certain degree of flexibility to enable the belt 86 to smoothly run over the rotatable segments 80. The flexibility of the belt 86 can be set through the use of pulleys 82 and a belt tensioner 84 as indicated in Fig. 10b.

In the present example all rotatable segments 80 are rotated in the same direction of rotation. It is possible to include rotatable segments that rotate in opposite directions or at different speeds, for example, the speed of rotation of the rotatable segments 80 arranged at an outer side 88 of the table 46 could rotate faster or slower than those arranged at the inner side 90 of the table 46.

It is also possible to adjust the speed of rotation during the coating process to adapt to different layer thickness deposited on the spherical objects 12.

It is further possible to arrange two, three, four or more zones of activated rotation, i.e. a plurality of such rotatable segments 80 per rail 72, 74.

Fig. 11 shows a further kind of deposition apparatus 10. This comprises a spiral track 70' that extends between the axis 22 and the outer side 88 of the support 36 having an introduction end 92 arranged at the axis 22 and an extraction end 94 arranged at the outer side 88 of the support 36. The spiral track 70' also comprises first and second rails 72', 74' for constraining the movement of the spherical object 12 between the introduction end and the extraction end.

Due to the centrifugal force acting on the spherical objects 12 while the table rotates the spherical objects 12 spiral outwardly towards the sidewall 20 of the chamber 14 arranged at the outer side 88. As the spherical objects 12 spiral outwardly they also rotate about two axes about themselves.

In order to prevent the spherical objects from becoming scratched as they are moved outwardly the rails 72', 74' comprise curved surfaces that come into contact with the spherical objects 12 in order to constrain the movement of the spherical objects 12.

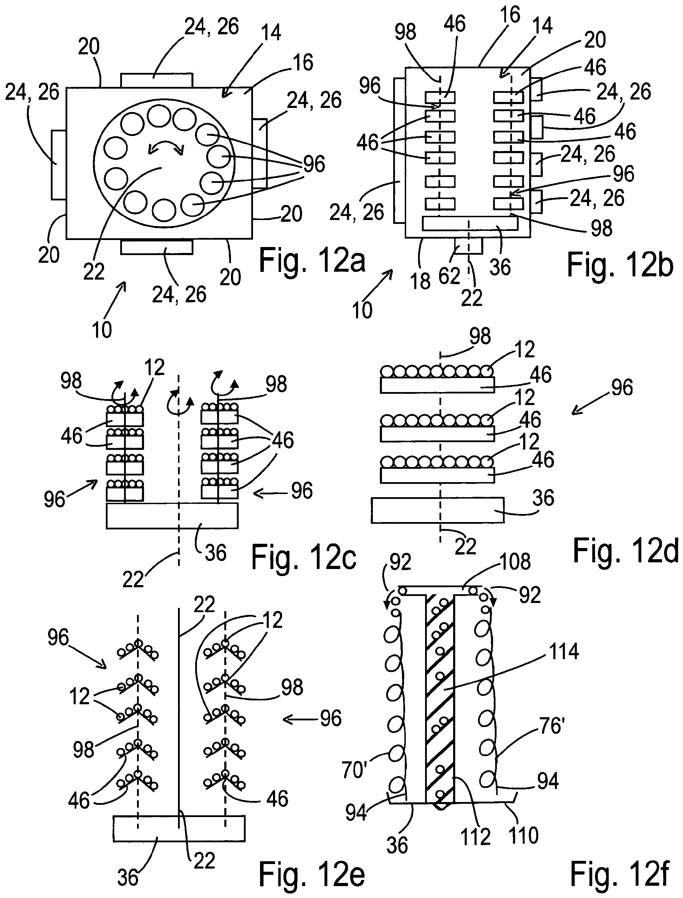

Fig. 12a shows a schematic top of a batch processing deposition apparatus 10. In this deposition apparatus 10 the sources 24, 26 of coating material are arranged at the sidewalls 20. The deposition apparatus 10 comprises a plurality of fixtures 96 that extend within the chamber in parallel to the axis 22 of the chamber 14 between the top side 16 and the bottom side 18.

Fig. 12b shows a part sectional schematic illustration of the deposition apparatus 10 of Fig. 12a. Two fixtures 96 can be seen in this illustration. The fixtures 96 are arranged on the support 36 and comprise a plurality of tables 46 rotatable about the axis 22 of the chamber 14. Each table is also configured to be rotated about an axis 98 of the fixture 96.

The plurality of tables 46 are arranged one after another along said axis 98 of rotation, with the axis 98 of rotation of the fixtures 96 extending at least substantially in parallel to or in parallel to the axis 22 of the chamber 14.

The use of fixtures 96 for coating spherical objects 12 means that these can be coated in existing deposition apparatus 10. After a coating process has been carried out the fixtures 96 are removed from the chamber 14 and either new fixtures 96 with a fresh batch of spherical objects 12 are introduced into the chamber 14, or the previous fixtures 96 with a fresh batch of spherical objects 12 is reintroduced into the chamber 14 in order to coat the fresh batch of spherical objects 12.

Fig. 12c shows a drawing similar to that of Fig. 12b, the difference being that a plurality of spherical objects 12 are respectively arranged at the tables 46 of the fixtures 96. As also indicated the respective fixtures are configured to be rotated about the axis 98 of rotation of the fixtures 96 and the fixtures 96 are arranged on the support 36 that is configured to be rotated about the axis 22 of the chamber 14.

Fig. 12d shows a further type of fixture 96 in which the axis 98 of rotation of the fixture 96 coincides with the axis 22 of the chamber 14. The fixture 96 comprises a plurality of tables 46 arranged one after the other in parallel to the support 36 of the deposition apparatus 10.

Fig. 12e shows a further type of fixture 96. In this design the top surface 60 of each table 46 is formed such that it resembles the shape of a truncated cone in a cross-section in parallel to the axis 98 of rotation of the fixture 96. The spherical objects are held in baskets 32 similar to the design shown and taught in Fig. 4b.

Fig. 12f shows a further type of deposition apparatus 10. The deposition apparatus 10 comprises a plurality of spiral tracks 70' that each extend from a first side 108 of the apparatus 10 to a second side 110 of the deposition apparatus 10 in parallel to the axis 22 of the chamber 14. The respective spiral track 70' extends from the introduction end 92 arranged at the first side 108 to the extraction end 94 at the second side 110. As discussed in the foregoing each spiral track 70' first and second rails 72', 74' for constraining the movement of the spherical object 12 between the introduction end 92 and the extraction end 94.

Each of the first and second rails 72', 74' comprises a curved surface, with the curved surface being arranged at least in a region in which the respective rail 72', 74' is configured to constrain the movement of the spherical objects 12.

The deposition apparatus 10 further comprises a return 112 that returns the spherical objects 12 from the extraction end 94 to the introduction end 92. In the present example the return 112 is arranged at the axis 22 of the chamber 14. The return also comprises a track 114 via which the spherical objects 12 are returned to the introduction end 92.

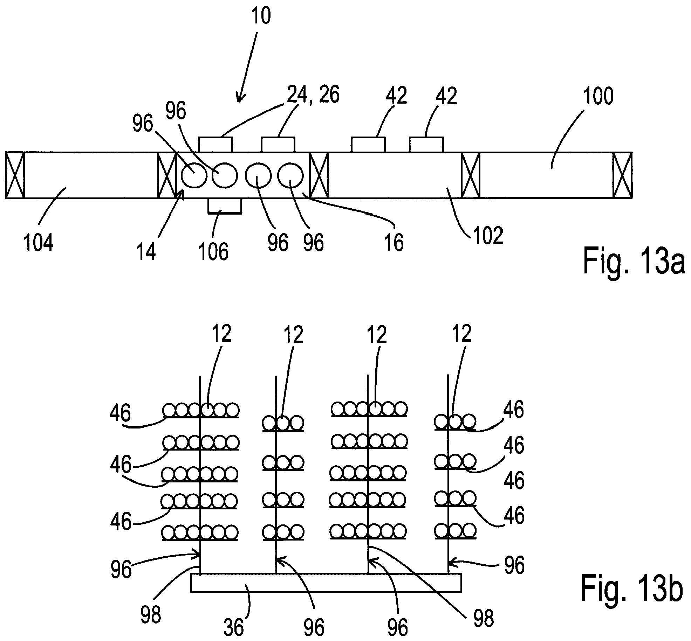

Figs. 13a shows a schematic top view of parts of an inline coating system in which the deposition apparatus 10 comprises a plurality of fixtures 96. In inline systems the fixtures 96 are moved within the chamber 14. In the example of the drawing of Fig. 13a, the spherical objects 12 are moved from the right to the left in the direction of the arrow.

The spherical objects 12 are loaded into the deposition apparatus 10 at the first chamber 100. The spherical objects 12 are then moved into the second chamber 102 where they are etched using the plasma source 42. Following their etching the spherical objects 12 are moved into the chamber 14 for coating. As indicated the chamber 14 is a vacuum chamber that can be evacuated like the second chamber 102 using a vacuum pump 106. The sources 24, 26 are arranged at the sidewalls 20. Following the coating process the fixtures 96 comprising the spherical objects 12 can be removed via the chamber 104.

Fig. 13b shows a schematic side view of the fixtures 96 arranged in the inline coating system of Fig. 13a. Four fixtures 96 are shown each arranged on the support 36 and each comprising a plurality of tables 46 arranged one after another along the axis 98 of rotation of the fixtures 96. During the coating process each of the tables 46 is only rotated about the axis 98 of rotation of the fixtures 96 and the support 36 remains stationary.

The fixtures 96 shown in Figs. 12 and 13 each comprise a plurality of tables 46. The plurality of tables 46 of each fixture 96 can comprise at least one of:
one or more tracks 70; 70' arranged on said table 46 or said fixture and said tracks 70; 70' being configured to constrain the movement of the spherical objects 12 around the axis 98 of rotation of the fixtures 96;
at least one device 38 for producing rotational movement of the spherical objects 12 around first and second axes relative to the table 46, with the second axis being arranged oblique to the first axis; and
one of a disc shaped basket having a base for carrying the spherical objects 12 and a plurality of segment shaped baskets 32 each having a base 34 for carrying the spherical objects 12.

The fixtures 96 shown and discussed in the foregoing can either be driven by the same motor 62 as causes the rotation of the support 36, e.g. via a transmission or gear or comprise a different motor that either drives all of the fixtures directly, indirectly or a separate motor may be provided for each fixture 96.

The tables 46 of the fixtures 96 discussed in relation to Figs. 12 and 13 can hence comprise the features previously discussed in relation to Figs. 3 to 11 relating to the tracks 70, 70', the baskets 32 and the wiper arms 66.
In all of the examples discussed in the foregoing the respective devices 38, supports 36 and tables 46 are configured to interact with one another such that the spherical objects are caused to rotate about first and second axes relative to the support 36, with the second axis being arranged oblique to the first axis.

This is done in order to create a uniform coating on the spherical objects 12. Using a stationary coating apparatus the shaded regions of the spherical objects 12 cannot be coated and it is extremely difficult if not even impossible to turn the spherical objects 12 in a fixed arrangement such that a uniform coating can be formed thereon. By rotating the spherical objects about several axes of rotation about themselves and about the axis 22 of the chamber each part surface of the spherical objects 12 can be exposed to the same amount of deposition material to form a uniform coating on the spherical objects 12.

By way of example, the spherical objects 12 are ball bearings of stainless steel and a multi-layered coating is formed on these stainless steel balls. For example, stainless steel balls of 10 to 15 mm diameter can be coated with a coating having a thickness of 1.5 µm thickness, of which one layer is 0.2 µm Cr, a further layer is a gradient layer of CrWC having a thickness of 0.3 µm and the third layer is a 1 µm thick layer of WC-C:H.

The thickness of the layer of coating produced on the respective spherical object 12 depends on the time of exposure each spherical object 12 is subjected to in the chamber 14.

Generally speaking spherical objects 12 of 5 mm to 100 mm, preferably of 8 to 60 mm, in particular of 9 to 20 mm diameter can be coated by means of one of the deposition apparatus 10 discussed in the foregoing. Single layers, multiple layer or gradient layers can be produced on the spherical objects 12 in a manner known per se to the person skilled in the art with respect to objects (not shown) arranged in a fixed arrangement on a table in a deposition apparatus.

The deposition apparatus 10 discussed in the foregoing are circular systems and ensure that the spherical objects 12 rotate around a centre, i.e the axis 22 of the chamber 14. In this way the spherical objects face the cathodes 24', 26' mounted at the top of the system several times during a coating process so that thick single layers, multi-layers and gradient layers can be formed on the spherical objects 12. The use of apertures 50 in the baskets 32, or tracks 70 forms a grid on the table 46 via which dust can fall and be removed from the spherical objects 12 improving the quality of coating achieved.

In order to minimize the non-deposition time per batch the volume of the system 10 can be decreased so that less of a volume has to be evacuated after the removal of a previous batch and introduction of a new batch.

The system makes available a dedicated system for the treatment of spherical objects 12 in order to achieve a uniform PVD layer thereon. The uniformity is guaranteed by introducing at least two rotational components at the spherical objects 12 relative to the support 36 so that each part surface of the spherical objects 12 sees each cathode 24', 26' for the same amount of exposure time to form a uniform coating thereon.

The deposition times depend on the speed of rotation of the spherical objects 12 about the axis 22 and the amount of deposition material introduced into the chamber 14. By way of example the table 46 can be rotated at speeds selected in the range of 0.1 to 10 RPM. The one or more wiper arms 66 can additionally be rotated at speeds of rotation selected in the range of 0.1 to 1000 RPM. This causes the 15 mm diameter spherical objects 12 to rotate about themselves at speeds of 0.1 to 100 Hz (is this correct???).

On coating the spherical objects 12 these are introduced into the deposition apparatus 10. The spherical objects 12 are then caused to rotate about first and second axes relative to at least one support 36, while the spherical objects 12 rotate about themselves and about the axis 22 a coating is deposited on the spherical objects 12 by means of one or more sources 24, 26 of coating material arranged at the top side 16 of the deposition apparatus 10.

### List of reference numerals:

- 10: deposition apparatus
- 12: spherical object
- 14: chamber
- 16: topside
- 18: bottom side
- 20: sidewall
- 22: axis
- 24: source of coating material
- 24', 24", 24'": cathode
- 26: source of coating material
- 26': cathode
- 28: lid
- 30: base
- 32: basket
- 34: base
- 36: support
- 38: device
- 40: anode of 42
- 42: plasma source
- 44: internal member
- 46: table
- 48: grid
- 50: aperture
- 52: sidewall
- 54: sidewall
- 56: equator
- 58: eccentric axis
- 60: top surface
- 62: motor
- 64: base part
- 66: wiper arm
- 68: sidewall
- 70, 70': track, spiral track
- 72, 72': first rail
- 74, 74': second rail
- 76: connecting member
- 78: deflection member
- 80: rotatable member
- 82: pulley
- 84: belt tensioner
- 86: belt
- 88: outer side
- 90: inner side
- 92: introduction end
- 94: extraction end
- 96: fixture
- 98: axis of rotation of 96
- 100: chamber
- 102: chamber
- 104: chamber
- 106: vacuum pump
- 108: first side
- 110: second side
- 112: return
- 114: track

## Claims

1. A deposition apparatus (10) for coating spherical objects (12), the deposition apparatus (10) comprising:
a chamber (14), in particular a vacuum chamber (14), having a top side (16) and a bottom side (18) and sidewalls connecting (20) the bottom side (18) to the top side (16), wherein an axis (22) of the chamber (14) extends between the top side (16) and the bottom side (18),
one or more sources (24, 26) of coating material arranged at the chamber (14) at one of the top side (16) and the sidewall (20), with the one or more sources (24, 26) of coating material facing into the chamber (14),
at least one support (36) for the spherical objects (12) disposed in the chamber (14) opposite to the top side (16) and spaced apart from the one or more sources (24, 26) of coating material,
at least one device (38) for producing rotational movement of the spherical objects (12) around first and second axes relative to the at least one support (36), with the second axis being arranged oblique to the first axis.

2. A deposition apparatus (10) in accordance with claim 1, wherein the at least one support (36) comprises one of a fixed table (46) and a table (46) rotatable about the axis (22).

3. A deposition apparatus (10) in accordance with claim 1 o claim 2, further comprising one or more fixtures (96), wherein the one or more fixtures (96) are arranged on the support (36) and comprise one or more tables (46) rotatable about the axis (22).

4. A deposition apparatus (10) in accordance with at least one of the preceding claims, further comprising one or more tracks (70; 70') configured to constrain the movement of the spherical objects (12) around the axis (22), with the tracks preferably being arranged on said table (46).

5. A deposition apparatus (10) in accordance with claim 4, wherein the track is selected as one of a circular track (70), a spiral track (70'), a circular track (70) with deflectors (78), and a non-circular closed loop track.

6. A deposition apparatus (10) in accordance with claim 4 or claim 5,
wherein each track (70) is formed by first and second rails (72, 74), with the first rail (72) being configured to be moved around the axis (22), optionally while the second rail (74) is fixed in position relative to the axis (22); and/or wherein each track (70) is formed by first and second rails (72, 74), with deflection elements (78) being arranged between the first and second rails (72, 74), with the deflection elements 78 preferably being one of fixed in position, moveable in position in particular rotatable about an axis or axially, tangentially and/or radially displaceable; and/or
wherein each track (70) is formed by first and second rails (72, 74), with each of the first and second rails (72, 74) comprising a longitudinal axis and with at least the first rail (72) being configured to be rotated its longitudinal axis; and/or
wherein each track (70) is formed by first and second rails (72, 74), wherein each of the first and second rails (72, 74) comprises a longitudinal axis and at least some of the first and second rails (72, 74) each comprising at least one rotatable segment (80) arranged along the longitudinal axis of the rail (72, 74), with the at least one rotatable segment (80) being configured to be rotated about the longitudinal axis, optionally while the remainder of each rail (72, 74) is fixed in position; and/or
wherein each track (70) is formed by first and second rails (72, 74), wherein the first and second rails (72, 74) comprise a curved surface, with the curved surface being arranged at least in a region in which the track (70) is configured to constrain the movement of the spherical objects (12).

7. A deposition apparatus (10) in accordance with at least one of the preceding claims, wherein the at least one device comprises one or more wiper arms (66) extending outwardly relative to the axis (22), the wiper arms (66) extending either radially or in an axial plane inclined with respect to a radial direction, with the one or more wiper arms (66) preferably being arranged on the table (46).

8. A deposition apparatus (10) in accordance with at least one of the preceding claims, wherein the device (38) comprises one of a disc shaped basket having a base for carrying the spherical objects (12) and a plurality of segment shaped baskets (32) each having a base (34) for carrying the spherical objects (12), and the support (36) optionally comprises a table (46) supporting the basket(s).

9. A deposition apparatus (10) in accordance with claim 8, wherein the base (34) of the or each basket (32) is inclined with respect to the axis (22) of the chamber (14), for example, in the manner of a swash plate.

10. A deposition apparatus (10) in accordance with claim 8 or claim 9, wherein the basket(s) either rotate(s) with the table (46) or relative to the table (46), optionally about an axis (58) eccentric to an axis (22) of the table (46).

11. A deposition apparatus (10) in accordance with one of claims 8 to 10, wherein the or each base (34) is formed as a grid (48) having apertures (50) for the spherical objects (12) and the or each basket (32) rotates relative to the table (46).

12. A deposition apparatus (10) in accordance with claim 11, wherein the apertures (50) comprise segments of a track (70); and/or
wherein the apertures (50) are configured to engage the spherical objects (12) at an equator (56), in a plane above the equator (56) or in a plane below the equator (56).

13. A deposition apparatus (10) in accordance with at least one of the preceding claims, wherein the deposition apparatus (10) further comprises at least one motor (62) for driving the support (36) and/or the device (38) around the axis (22); and/or
wherein the device (38) comprises at least one deflection member (78) that is configured to be moved in at least one of a tangential direction with respect to the axis (22) and in parallel with the axis (22).

14. A deposition apparatus (10) in accordance with at least one of the preceding claims, further comprising a spiral track (70') that extends between the axis (22) and an outer side (88) of the support (36) having an introduction end (92) arranged at the axis (22) and an extraction end (94) arranged at the outer side (88) of the support (36), with the spiral track (70') comprising at least one rail (72', 74') for constraining the movement of the spherical object (12) between the introduction end (92) and the extraction end (94), wherein each of the at least one rails (72', 74') comprises a curved surface, with the curved surface being arranged at least in a region in which the rail (72', 74') is configured to constrain the movement of the spherical objects (12); or
wherein the deposition apparatus (10) further comprises one or more spiral tracks (70') that each extend from a first side (108) of the deposition apparatus (10) to a second side (110) of the deposition apparatus (10) in parallel to the axis (22) of the chamber (14) from an introduction end (92) to an extraction end (94); with the spiral track (70') comprising at least one rail (72', 74') for constraining the movement of the spherical objects (12) between the introduction end (92) and the extraction end (94), wherein each of the at least one rails (72', 74') comprises a curved surface, with the curved surface being arranged at least in a region in which the rail (72', 74') is configured to constrain the movement of the spherical objects (12); optionally wherein the deposition apparatus (10) comprises a return (112) that returns the spherical objects (12) from the extraction end (94) to the introduction end (92), with the return (112) preferably being arranged at the axis (22) of the chamber (14).

15. A deposition apparatus (10) in accordance with at least one of the preceding claims, wherein a plurality of coating sources (24, 26) are provided, with two, three or more different kinds of coating sources (24, 26) being provided and optionally with several of each kind of coating source (24, 26) being provided; and/or
wherein the coating sources (24, 26) are selected from the group of members consisting of: a PVD coating source, a PaCVD coating source, a CVD coating source, a PeCVD coating source, a HIPIMS source, a dual magnetron sputtering source, a microwave source, a glow discharge source, a plasmasource, a rotatable magnetron, an arc source, a pulsed arc source, a sputtering source, a filtered arc source and combinations of the foregoing; and/or
wherein each of the one or more coating sources (24, 26) comprises a cathode (24', 26'), wherein the cathode is optionally a circular shaped cathode (24'), a rectangular shaped cathode (24"), a pie shaped cathode (24'") or a square shaped cathode.

16. A fixture (96) for a deposition apparatus (10), preferably in accordance with at least one of the preceding claims, wherein the fixture (96) comprises a plurality of tables (46) rotatable about an axis of rotation, with the plurality of tables (46) being arranged one after another along said axis of rotation, wherein each table of the fixture comprises at least one of:
one or more tracks (70; 70') arranged on said table (46) and said tracks (70; 70') being configured to constrain the movement of the spherical objects (12) around the axis of rotation;
at least one device (38) for producing rotational movement of the spherical objects (12) around first and second axes relative to the table (46), with the second axis being arranged oblique to the first axis; and
one of a disc shaped basket having a base for carrying the spherical objects (12) and a plurality of segment shaped baskets (32) each having a base (34) for carrying the spherical objects (12).

17. A method of coating spherical objects (12), the method comprising the steps of:
- introducing the spherical objects (12) into a deposition apparatus (10), in particular in accordance with at least one of the preceding claims;
- producing a rotational movement of the objects (12) around first and second axes relative to at least one support (36) for the spherical objects (12), with the at least one support (36) being arranged within the deposition apparatus (10),
- optionally etching the spherical objects (12) within the deposition apparatus prior to coating the spherical objects (12); and
- depositing a coating on the spherical objects (12) by means of one or more sources (24, 26) of coating material arranged at at one of a top side (16) of the deposition apparatus (10) and a sidewall (20) of the deposition apparatus (10), with said one or more sources (24, 26) of coating material facing into a chamber (14) of the deposition apparatus (10).

18. A method of coating spherical objects (12) arranged at a fixture (96), the method comprising the steps of:
- introducing the spherical objects (12) into said fixture, in particular in accordance with claim 16;
- producing a rotational movement of the spherical objects (12) around first and second axes relative to an axis of rotation of a table (46) supporting the spherical objects (12), with the table (46) being arranged at the fixture,
- optionally etching the spherical objects (12) at the fixture (96) prior to coating the spherical objects (12); and
- depositing a coating on the spherical objects (12) by rotating these relative to at least one source (24, 26) of coating material.
